# EUROPEAN PATENT SPECIFICATION

(11) **EP 0 825 680 B1**
(45) Date of publication and mention of the grant of the patent: **07.03.2001**
(21) Application number: 97306469.4
(22) Date of filing: 22.08.1997
(51) Int. Cl.: H01R 12/06

(54) **Deformable pin electrical connector**
Verformbarer elektrischer Verbindungsstift
Connecteur électrique ayant des broches déformables

(30) Priority: 23.08.1996 US 702348
(43) Date of publication of application: 25.02.1998
(73) Proprietor: CTS Corporation, Elkhart Indiana 46514-1899 (US)
(72) Inventor: Archer, Ian, Strathaven, Lanarkshire (GB)
(74) Representative: Amann, Hannes Gerhart

(56) References cited:
- EP-A- 0 325 296
- EP-A- 0 664 576
- US-A- 4 076 356
- US-A- 4 446 505
- US-A- 4 911 645
- US-A- 5 106 310

## Description

This invention relates to a deformable pin electrical connector. More particularly, it relates to a connector for insertion into plated through holes in printed circuit boards; specifically, a pin connector that can electrically and mechanically connect two or more printed circuit boards (PCBs).

Deformable pin connectors have existed for many years. They are used to shorten assembly time and allow for later removal of connected items such as PCBs. When a pin is inserted into a metal plated hole the pin will deform in shape and wedge into the plated through-hole. Thus, an electrical contact is made and a secure hold is achieved. Known methods typically require a pin tip to be inserted into and through a hole, enabling the pin to be soldered at the back of the printed circuit board to create the electrical contat and to securely hold the pin in place.

Consumers have required smaller and smaller computer cases in recent years, from towers to mini-towers. As a result, PCBs and other circuit card physical arrangements have needed to become more compact. Thus, PCBs have needed to be placed very close together. The situation often occurs when a mother board needs to be connected to several equally large daughter boards. The typical connecting method is to connect the daughter boards perpendicular to the mother board. However, this perpendicular arrangement requires a large PCB profile necessitating a larger computer case.

A parallel arrangement of the daughter cards to the mother boards is known to create a smaller profile. This arrangement works like a stack of playing cards. The difficult job is to try to both electrically and physically connect all of the cards together.

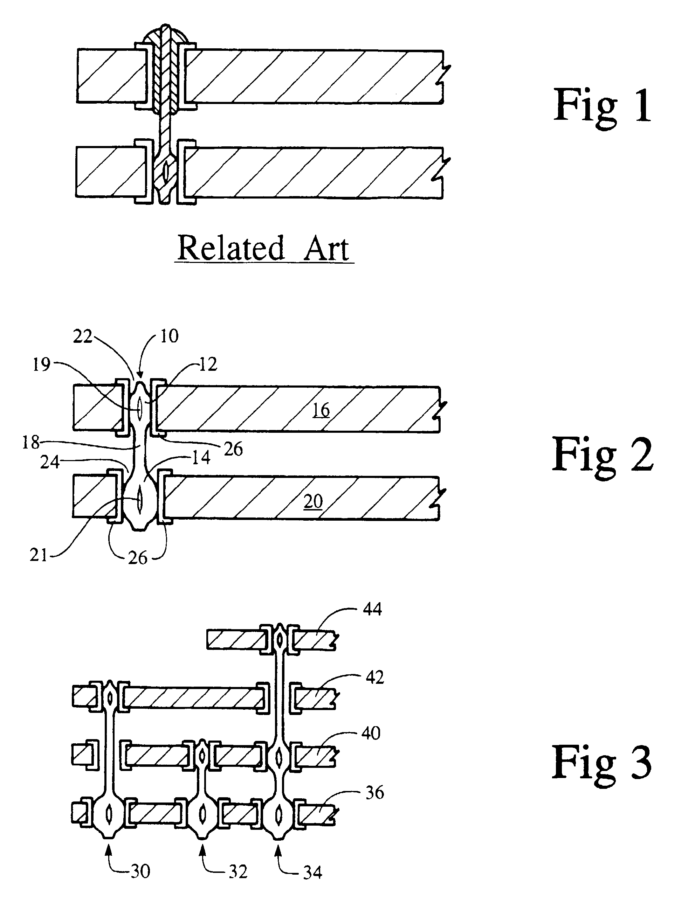

There are several known methods of connecting several parallel cards. For example, as shown in Figure 1 of the accompanying drawings, one type of connector has pins designed with a deformable portion near the base of each pin and a longer pin section extending therefrom. Thus, it is possible to connect two PCBs by inserting the pin into the first PCB and thereby deformably fitting the pin thereto, the extended pin portion being inserted through the second PCB through-hole and thereafter welded to create a secure electrical fit between the two PCBs.

One major drawback of this method is that it is expensive and time consuming to weld the end of each pin to the second PCB. One connector could have as many as eighty or more closely positioned pins. The soldering of these pins requires extra time, welding equipment, and solder materials. Thus, a need exists for a method of connecting several PCBs without the need for soldering.

Examples of relevant prior art are:- U.S. Patent No. 5,374,204, which relates to an electrical terminal with a compliant pin section; U.S. Patent No. 5,259,111 which relates to a method of producing a terminal connector for a base board: U.S. Patent No. 5,230,642, which relates to a press-fit contact; U.S. Patent No. 5,106,310, which relates to a Z-axis pin connector for stacked printed circuit board assemblies; U.S. Patent No. 4,923,414 which relates to a compliant section for circuit board contact elements; U.S. Patent No. 4,828,514, which relates to an electrical connector with a compliant section; U.S. Patent No.4,728,164 which relates to an electrical contact pin for printed circuit boards; and U.S. Patent No. 4,446,505, which relates to an electrical connector for interconnecting printed circuit boards.

According to one aspect of the present invention, there is provided a connector pin having first and second ends and spaced first and second deformable portions. the first deformable portion being located at or adjacent the first end and having a smaller width than the second deformable portion and the second portion being located at or adjacent the second end.

As compared to U.S. Patent No. 4 446 505, when the pin is used in combination with a printed circuit board assembly, the smaller deformable portion can be passed freely through a hole in a first board to deformably fit in a hole in a second board, the larger deformable portion being a deformable fit in the hole in the first board through which the smaller deformable portion has been freely passed.

According to another aspect of the present invention, there is provided a combination connector pin and printed circuit board (PCB) assembly, comprising:
a) first and second PCBs the first PCB having smaller holes than the holes of the second PCB, the holes being designed to receive press-fit deformable connector pin heads; and
b) a double headed connector pin having first and second ends and first and second deformable heads the first head being located at or adjacent the first end and having a smaller width than the second head located at or adjacent the second end, wherein
c) the first head is deformably held within the first hole and the second head is deformably held within the second hole.

According to a third aspect of the invention there is provided an assembly of press-fit electrical connector pins, comprising:
a) at least two connector pins, each pin having first and second ends and first and second deformable heads, the first head located at or adjacent the first end having a smaller width than the second head located at or adjacent the second end. and
b) a connecting strip having a first deformable connector pin releasably attached to a first side of the connecting strip and a second deformable connector pin releasably attached to a second side opposite the first side of the connecting strip.

Thus, the present invention provides a pin that has at least two compliant sections for press fitting into a plated through-hole in a PCB or the like. In particular, each compliant section has a different size diameter. Specifically, the top compliant section is the smallest, the bottom compliant section is the largest in diameter, and the remaining compliant sections will gradually increase in size as they are located from the tip to the base of the pin.

Additionally, the invention provides a strip of multi-compliant pins mounted upon a linear strip of material for easy removal of each pin from the strip.

The invention also provides a connector pin/PCB combination using the aforesaid pins.

The invention is further described with reference to the accompanying drawings. in which:-
Figure 1 is a cross sectional view of a prior art embodiment;
Figure 2 is a cross sectional view of a first embodiment of the connector pin according to the invention;
Figure 3 is a cross sectional view of another embodiment of the connector pin according to the invention; and
Figure 4 is a top view of the connector pin of Figure 2 attached to a strip containing several other connector pins.

It is to be noted that the drawings of the invention are not to scale, but are merely schematic representations not intended to portray specific parameters of the invention. The drawings depict only typical embodiments of the invention and therefore should not be considered as limiting the scope of the invention as defined by the appended claims.

The present invention provides a method for attaching several parallel oriented printed circuit boards (PCBs) together, as shown in Figures 2 and 3.

Referring to Figure 2, a connector pin 10 has first and second deformable or compliant portions 12 and 14. The first compliant portion 12 is smaller than the second compliant portion 14. A neck 18 connects the first and second compliant portions. Each compliant portion 12 and 14 has a hole 19 and 21 respectively located therein.

Also shown are two printed circuit boards (PCBs) 16 and 20 each having a through-hole 22 and 24 plated with an electrical conductive material 26.

In use, the first deformable portion 12 is inserted into and through a larger dimensioned through-hole 24 of one PCB 20 without deforming the plated material 26 or deforming the first compliant portion 12. As pin 10 continues to be inserted into the first circuit board 20, the neck portion 18 will extend into and through the larger through-hole 24 without any deformation to either the pin or plated material 26. The small compliant portion 12 will eventually reach the smaller dimensioned plated through-hole 22. The compliant portions 12 and 14 are sized to be slightly larger than the respective plated through-holes 22 and 24 located in the respective PCBs 16 and 20. As pin 10 is inserted to its full extent both compliant portions 12 and 14 will begin to collapse the respective holes 19 and 21 as a result from contacting the smaller diameter plated through-holes 22 and 24. Upon reaching the full extent of insertion compliant sections 12 and 14 have been both physically deformably locked into the electrical conductive material 26 and electrically coupled to the plated through-holes.

Figure 3 shows an exemplary method and design for attaching several PCBs. In particular, three connector pins 30, 32 and 34 and four PCBs 36, 40, 42 and 44 are shown. The first pin 30 is mechanically and electrically coupled to the first 36 and third 42 PCBs, and the second pin 32 is mechanically and electrically coupled to the first 36 and second 40 PCBs. The third pin 34 is mechanically and electrically coupled to the first 36, second 40, and fourth 44 PCBs, and not to the third 42 PCB.

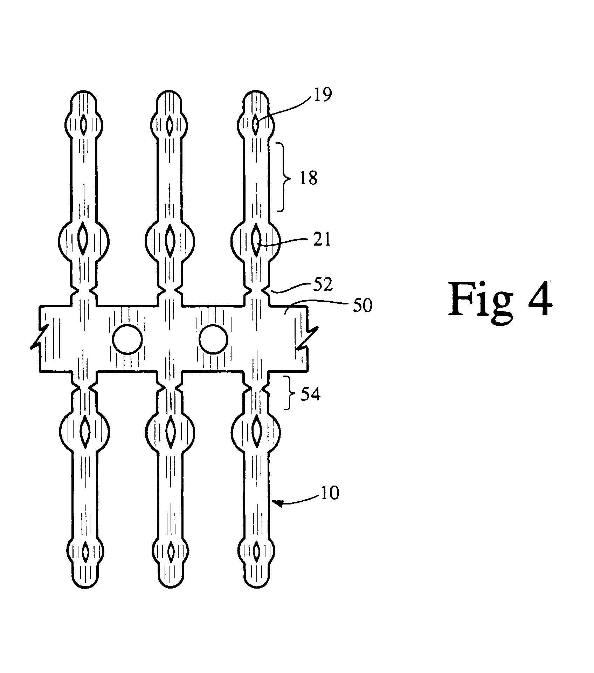

With reference to Figure 4, there is illustrated a set of pins 10 mounted upon a strip 50 having grooves 52 along the attachment portion 54 for providing quick easy breaking or removing of the pin 10 from the strip 50.

It will be appreciated that there are several advantages arising from using the invention. For example, there is an elimination of the prior welding process to attach the last PCB to the pin as illustrated in Figure 1. The use of thin metal or conductive material in fabricating the pin and strip makes it easy to both remove the pins from the strip and press-fit the pins into a PCB. The fact that the pins can be designed to interconnect several PCBs in different arrangements allows for greater interconnectability. The fact that several PCBs can be located in planar relationship to each other allows for lower profiles or height needed to interconnect several PCBs.

Although the illustrated embodiments concern connecting the pins to PCBs it will be appreciated that the preferred embodiment would work to connect anv circuitry needing an interconnection pin, such as ceramic based circuitry. Additionally, although the preferred embodiment discloses the use of rounded compliant sections 12 and 14, any shape such as oval or a three-dimensional shape would be suitable. It is envisaged that the holes 19 and 21 could be differently designed and, for example, it is possible that the compliant sections may not have any holes therein, but have a thinning of the material for example. In fact any arrangement that will provide for press-fit connection of the pin to a plated through-hole would be satisfactory.

## Claims

1. A connector pin (10) having first and second ends and spaced first and second deformable portions (12, 14) the first deformable portion being located at or adjacent the first end and having a smaller width than the second deformable portion, and the second portion being located at or adjacent the second end.

2. A combination connector pin and printed circuit board (PCB) assembly, comprising:
a) first and second PCBs (16, 20) the first PCB (16) having smaller holes (22) than the holes (24) of the second PCB (20), the holes being designed to receive press-fit deformable connector pin heads; and
b) a double headed connector pin (10) having first and second ends and first and second deformable heads (12, 14), the first head (12) being located at or adjacent the first end having a smaller width than the second head (14) located at or adjacent the second end, wherein
c) the first head is deformably held within one hole of the first PCB and the second head is deformably held within one hole of the second PCB.

3. A combination connector pin and printed circuit board (PCB) assembly, comprising:
a) first, second and third PCBs (42, 40, 36), the first PCB (42) having holes smaller than the second and third PCBs (40, 36) and the second PCB (40) having holes smaller than the third PCB (36), where the holes are designed to receive press-fit deformable connector pin heads;
b) a double headed connector pin (30) having first and second ends and first and second deformable heads, the first head located at or adjacent the first end having a smaller width than the second head located at or adjacent the second end; wherein
c) the first head is deformably held within one hole of the first PCB, the second head is deformably held within one hole of the third PCB, and the shaft of the pin extends through the second PCB, which is located between the first and third PCBs.

4. An assembly of press-fit electrical connector pins, comprising:
a) at least two connector pins (10) each pin having first and second ends and first and second deformable heads, the first head located at or adjacent the first end having a smaller width than the second head located at or adjacent the second end. and
b) a connecting strip (50) having a first deformable connector pin releasable attached to a first side of the connecting strip and a second deformable connector pin releasably attached to a second side opposite the first side of the connecting strip.

5. An assembly of press-fit electrical connector pins as claimed in claim 4. wherein the first and second heads have portions therein defining a hole (19, 21) in each head.

6. The combination connector pin and printed circuit board (PCB) assembly of claim 3, wherein the first and second heads have portions therein defining a hole in each head.

7. The combination connector pin and printed circuit board (PCB) assembly of claim 2, wherein the first and second heads have portions therein defining a hole in each head.

8. The connector pin of claim 1, wherein the first and second deformable portions have portions therein defining a hole in each deformable portion.

## Patentansprüche

1. Verbindungsstift (10) mit einem ersten und zweiten Ende und mit voneinander beabstandeten ersten und zweiten verformbaren Abschnitten (12, 14), wobei der erste verformbare Abschnitt an oder nahe dem ersten Ende angeordnet ist und eine kleinere Weite als der zweite verformbare Abschnitt hat, wobei der zweite Abschnitt an oder nahe dem zweiten Ende angeordnet ist.

2. Eine kombinierte Anordnung aus Verbindungsstift und Leiterplatte, enthaltend:
a) eine erste und zweite Leiterplatte (16, 20), wobei die erste Leiterplatte (16) kleinere Löcher (22) als die zweite Leiterplatte (20) aufweist, welche zur Aufnahme von verformbaren Verbindungsstiftköpfen in Presspassung ausgebildet sind; und
b) einen mit zwei Köpfen versehenen Verbindungsstift (10) mit einem ersten und zweiten Ende und einem ersten und einem zweiten verformbaren Kopf (12, 14), wobei der erste Kopf (12) an oder nahe dem ersten Ende angeordnet ist und eine kleinere Weite als der zweite Kopf (14) aufweist, der an oder nahe dem zweiten Kopf angeordnet ist, wobei
c) der erste Kopf verformbar innerhalb eines Loches in der ersten Leiterplatte und der zweite Kopf verformbar innerhalb eines Loches der zweiten Leiterplatte gehalten ist.

3. Eine kombinierte Anordnung aus Verbindungsstift und Leiterplatte, enthaltend:
a) eine erste, eine zweite und eine dritte Leiterplatte (42, 40, 36), wobei die erste Leiterplatte (42) Löcher aufweist, die kleiner als diejenigen in der zweiten und dritten Leiterplatte (40, 36) sind, und die zweite Leiterplatte (40) Löcher aufweist, die kleiner als diejenigen in der dritten Leiterplatte (36) sind, wobei die Löcher zur Aufnahme von verformbaren Verbindungsstiftköpfen in Presspassung ausgebildet sind;
b) einen mit zwei Köpfen versehenen Verbindungsstift (30), der ein erstes und ein zweites Ende und einen ersten und einen zweiten verformbaren Kopf aufweist, wobei der erste Kopf an oder nahe dem ersten Ende angeordnet ist und eine geringere Weite als der zweite Kopf aufweist, der an oder nahe dem zweiten Ende angeordnet ist; wobei
c) der erste Kopf verformbar in einem Loch der ersten Leiterplatte gehalten ist, der zweite Kopf verformbar in einem Loch der dritten Leiterplatte gehalten ist und der Schaft des Verbindungsstiftes sich durch die zweite Leiterplatte erstreckt, die zwischen der ersten und der dritten Leiterplatte angeordnet ist.

4. Anordnung von elektrischen Verbindungsstiften mit Presspassung, enthaltend:
a) mindestens zwei Verbindungsstifte (10), die jeweils ein erstes und ein zweites Ende und einen ersten und einen zweiten verformbaren Kopf aufweisen, wobei der erste Kopf an oder nahe dem ersten Ende angeordnet ist und eine kleinere Weite als der zweite Kopf aufweist, der an oder nahe dem zweiten Ende angeordnet ist, und
b) einen Verbindungsstreifen (50), der einen ersten verformbaren Verbindungsstift, der lösbar mit der einen Seite des verbindungsstreifens verbunden ist, und einen zweiten verformbaren Verbindungsstift aufweist, der lösbar mit einer zweiten gegenüberliegenden Seite des Verbindungsstreifens verbunden ist.

5. Anordnung von elektrischen Verbindungsstiften mit Presspassung nach Anspruch 4, wobei die ersten und zweiten Köpfe Abschnitte haben, welche ein Loch (19, 21) in jedem Kopf bilden.

6. Anordnung mit einer Kombination eines Verbindungsstiftes und einer Leiterplatte nach Anspruch 3, wobei der erste und der zweite Kopf jeweils Abschnitte aufweisen, die in jedem Kopf ein Loch bilden.

7. Anordnung mit einer Kombination eines Verbindungsstiftes und einer Leiterplatte nach Anspruch 2, wobei der erste und der zweite Kopf jeweils Abschnitte aufweisen, die in jedem Kopf ein Loch bilden.

8. Verbindungsstift nach Anspruch 1, wobei der erste und der zweite Kopf jeweils Abschnitte aufweisen, die in jedem Kopf ein Loch bilden.

## Revendications

1. Une broche de connecteur (10) ayant des première et deuxième extrémités et des premier et deuxième parties déformables (12, 14), la première partie déformable étant placée sur ou au voisinage de la première extrémité et ayant une largeur inférieure à celle de la deuxième partie déformable, et la deuxième partie étant placée sur ou au voisinage de la deuxième extrémité.

2. Un ensemble combiné broche de connecteur et carte à circuit imprimé (PCB), comprenant :
a) des première et deuxième PCB (16, 20), la première PCB (16) ayant des trous (22) de plus petites dimensions que les trous (24) de la deuxième PCB (20), les trous étant conçus pour recevoir des têtes de broche de connecteur déformables par ajustage serré ; et
b) une broche de connecteur à tête double (10), ayant des première et deuxième extrémités et des première et deuxième têtes déformables (12, 14), la première tête (12) placée sur ou au voisinage de la première extrémité ayant une largeur inférieure à celle de la deuxième tête (14), située au voisinage de la deuxième extrémité, dans laquelle
c) la première tête est maintenue de façon déformable à l'intérieur d'un trou de la première PCB et la deuxième tête est maintenue de façon déformable à l'intérieur d'un trou de la deuxième PCB.

3. Un ensemble combiné broche de connecteur et carte à circuit imprimé (PCB), comprenant :
a) des première, deuxième et troisième PCB (42, 40, 36), la première PCB (42) ayant des trous de dimensions inférieures à ceux des deuxième et troisième PCB (40, 36), et la deuxième PCB (40) ayant des trous de dimensions inférieures à ceux de la troisième PCB (36), les trous étant conçus pour loger des têtes de broche de connecteur déformables par ajustement serré ;
b) une broche de connecteur à tête double (30) ayant des première et deuxième extrémités, et des première et deuxième têtes déformables, la première tête, placée sur ou au voisinage de la première extrémité, ayant une largeur inférieure à celle de la deuxième tête, placée sur ou voisinage de la deuxième extrémité ; dans lequel
c) la première tête est maintenue de façon déformable à l'intérieur d'un trou de la première PCB, la deuxième tête est maintenue de façon déformable à l'intérieur d'un trou de la troisième PCB, et la tige de la broche s'étendant à travers la deuxième PCB, placée entre les première et troisième PCB.

4. Un ensemble de broches de connecteur électrique à ajustement serré, comprenant :
a) au moins deux broches de connecteur (10), chaque broche ayant des première et deuxième extrémités et des première et deuxième têtes déformables, la première tête, placée sur ou au voisinage de la première extrémité, ayant une largeur inférieure à celle de la deuxième tête placée sur ou au voisinage de la deuxième extrémité, et
b) une bande de liaison (50) ayant une première broche de connecteur déformable, fixée de façon désolidarisable sur une première face de la bande de liaison, et une deuxième broche de connecteur déformable, fixée de façon désolidarisable à une face opposée à la première face de la bande de connecteur.

5. Un ensemble de broches de connecteur électrique à ajustement serré selon la revendication 4, dans lequel les première et deuxième têtes ont, en leur sein, des parties définissant un trou (19, 21) dans chaque tête.

6. L'ensemble combiné de broche de connecteur et de carte à circuit imprimé (PCB) selon la revendication 3, dans lequel les première et deuxième têtes ont en leur sein des parties définissant un trou dans chaque tête.

7. L'ensemble combiné de broche de connecteur et de carte à circuit imprimé (PCB) selon la revendication 2, dans lequel les première et deuxième têtes ont en leur sein des parties définissant un trou dans chaque tête.

8. La broche de connecteur selon la revendication 1, dans laquelle la première et la deuxième parties déformables ont en leur sein des parties définissant un trou dans chaque partie déformable.
